(19) Europäisches Patentamt
European Patent Office
Office européen des brevets

(11) **EP 4 741 770 A1**

(12) **EUROPEAN PATENT APPLICATION**

(43) Date of publication:
**13.05.2026  Bulletin 2026/20**

(21) Application number: **24212392.5**

(22) Date of filing: **12.11.2024**

(51) International Patent Classification (IPC):
**G01D 5/14** *(2006.01)*       **G01D 18/00** *(2006.01)*
**G01D 5/20** *(2006.01)*       **H02K 11/21** *(2016.01)*
**H02P 6/16** *(2016.01)*       **H02P 6/18** *(2016.01)*

(52) Cooperative Patent Classification (CPC):
**G01D 18/008; H02P 6/16; H02P 6/182;**
G01D 5/145; G01D 5/20

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(71) Applicant: **HELLA GmbH & Co. KGaA
59552 Lippstadt (DE)**

(72) Inventors:
• **Molkenthin, Philipp
28816 Stuhr (DE)**
• **Constantin, Marius Alexandru
307370 Sacalaz (RO)**

(74) Representative: **Behr-Wenning, Gregor
HELLA GmbH & Co. KGaA
Rixbecker Strasse 75
59552 Lippstadt (DE)**

(54)    **A METHOD FOR CALIBRATING AN ANGULAR POSITION SENSOR**

(57)    The invention relates to a method for calibrating an angular position sensor (S), e. g. a contactless inductive position sensor (CIPOS) or a Hall sensor, arranged at an output shaft (12) of an actuator (100), wherein the actuator (100) is preferably provided for a vehicle application, e. g. for engine control, steering control, cooling control etc., wherein angular positions (V12) of the output shaft (12) obtained by the angular position sensor (S) and real angular positions (V12*) of the output shaft (12) calculated using angular positions (V11) of a motor shaft (11) will be compared.

Fig. 1

Processed by Luminess, 75001 PARIS (FR)

## Description

The invention is related to a method for calibrating an angular position sensor, especially a contactless inductive position sensor (CIPOS) or a Hall sensor, of an actuator, preferably for a vehicle application, e. g. for engine control, steering control, cooling control etc. Besides, the invention is related to a corresponding computer program product and corresponding electronic control unit configured to execute respective method. Further, the invention is related to a corresponding actuator with an angular position sensor and a respective electronic control unit configured for calibrating the angular position sensor.

Actuators for vehicle applications usually require internal angular position sensors, e. g. a contactless inductive position sensor (CIPOS), a Hall sensor or the like, at the output shaft for proper operation. One possible application is cooling control for components in electric cars, e.g. battery etc.

Actuators may be driven by a brushless motor and need to know the motor position very well in order to define the correct commutation timing. A Brushless motor may use either a "sensorless drive solution" and BEMF signal or a "sensored drive solution" (using a motor position sensor, like Hall switches, Hall sensor, another CIPOS sensor or the like) to determine the motor position.

The actuator internal angular position sensors at the output shaft of the actuators will be usually calibrated after actuator assembly.

For this aim, external angular position sensors with considerably high precision are usually used to calibrate the actuator internal angular position sensors at the output shaft of the actuators.

Drawbacks are however that production time and effort of actuators are increased due to this calibration process.

Synchronization of signals between the external angular position sensors and the actuator internal angular position sensor at the output shaft is challenging. Also, the output shaft of the actuator must be connected free of backlash to an external angular position sensor as any backlash compromises calibration result.

The resolution of the actuator internal angular position sensor at the output shaft is also limited due to constraints in the communication interface and thus limiting the benefit of the calibration process.

The aim of the present invention is to at least partially overcome at least one of the above-mentioned disadvantages. Preferably, the aim of the present invention is to provide an improved method for calibrating an angular position sensor, which may be executed with reduced time and effort, which requires reduced computational and physical resources and which provides improved results of the angular position sensor after calibrating process. Besides, the aim of the present invention is to provide a corresponding computer program product and corresponding electronic control unit configured to execute the respective method. Further, the aim of the present invention is to provide a corresponding actuator with an angular position sensor and a respective electronic control unit configured for calibrating the angular position sensor.

The invention provides:
a method for calibrating an angular position sensor, e. g. a contactless inductive position sensor (CIPOS) or a Hall sensor, especially arranged at an output shaft of an actuator, wherein the actuator is preferably provided for a vehicle application, e. g. for engine control, steering control, cooling control etc.

The actuator comprising:

- an electrical motor, especially a brushless dc motor, configured to drive a motor shaft and to provide an incremental sensor using a motor back EMF signal,
- a gear mechanism configured to provide a gear ratio between the motor shaft and the output shaft of the actuator.

The angular position sensor may be mounted at an output shaft of an actuator or in other gear stages of the gear mechanism. There may be actuators, where the exact position of the output shaft may be needed. There may be also actuators, where other gear stages and their positions may be of interest. The output shaft within the meaning of the invention may therefore be a particular shaft in one of the stages in the gear mechanism.

The method comprising:

- operating the angular position sensor to obtain angular positions of the output shaft,
- operating the electrical motor as the incremental sensor to determine angular positions and/or a number of revolutions of the motor shaft (which is especially equal to the number of electrical rotations and/or rollovers of the electrical motor),
- calculating real angular positions of the output shaft using the angular positions and/or the number of revolutions of the motor shaft,
- comparing the angular positions of the output shaft obtained by the angular position sensor and the real angular positions of the output shaft calculated using the angular positions and/or the number of revolutions of the motor shaft,
- calibrating the angular position sensor in dependence on the comparing.

Back EMF (or back electromotive force) is a voltage induced through the magnetic field in the motor.

The electrical motor used as an incremental sensor may count the number of electrical rotations and/or rollovers of the electrical motor, especially of revolutions of the motor shaft.

The idea of the invention is to use the signal of motor commutation (and preferably the fixed gear ratio of the gear mechanism) to calibrate the actuator internal position sensor at the output shaft of the actuator. Preferably this method may be executed completely actuator internally and without an external position sensor.

Thus, a plurality of benefits may be achieved with the help of this method:

- production time and effort of the actuator may be drastically reduced due to this calibration process,
- only reduced computational power and resources are necessary,
- only reduced hardware, without external position sensor, is necessary,
- improved calibration results may be achieved, etc.

Preferably, the gear ratio of the gear mechanism may be considered to calibrate the angular position sensor, especially by calculating the real angular positions of the output shaft using the angular positions and/or the number of revolutions of the motor shaft. The invention recognizes that by knowing the exact angular position and/or the number of revolutions of the motor shaft and further knowing the gear ratio of the gear mechanism between the motor shaft and an output shaft of the actuator, the real angular position of the output shaft may be calculated and used to verify the current sensor value.

Further, it may be advantageous, that the angular position sensor may be operating to obtain an angular position of the output shaft (or with other words a sensor value) every certain time slot, for example every 3 ms, during an operation of the electrical motor as the incremental sensor. Thus, a plurality of sensor values (or with other words plurality of angular positions of the output shaft) may be achieved which may be used in the improved calibrating process.

Furthermore, it may be advantageous, that the angular position sensor is operating to obtain a plurality of angular positions of the output shaft (or with other words a plurality of sensor values) for at least two (or more) electrical rotations and/or rollovers of the electrical motor, especially for at least two (or more) revolutions of the motor shaft. Two rollovers of the electrical motor may be preferably needed because of the gear ration. It may also be preferably to rotate more often for this aim.

Accordingly, it may be advantageous, that operating the electrical motor, especially with a constant speed, e. g. 300 rad/s, as the incremental sensor may be executed for at least two electrical rotations and/or rollovers of the electrical motor, especially for at least two (ore more) revolutions of the motor shaft.

This may be beneficial to be able to detect a maximal angular position (or a maximal sensor value) and a minimal angular position (or a minimal sensor value) of the output shaft and beyond that to calculate a resolution of the angular position sensor.

With other words, it may be beneficial to be able to obtain a whole set of sensor values between a minimal sensor value and a maximal sensor value. Moreover, a resolution of the angular position sensor may be determined in dependence on a minimal sensor value and a maximal sensor value.

At least two (ore more) revolutions of the motor shaft may be needed:

- First rollover may be needed to detect a zero-position if the output shaft and to get the mechanics to a constant speed,
- Second rollover may be needed to collect timely matching data of motor-spins and sensor values, which may be preferably used for the calibration.

Thus, the angular position of the output shaft may be precisely calculated using the motor shaft position. The calculated angular position of the output shaft may then be compared to the current sensor value (that is the current angular position of the output shaft according to the actuator internal angular position sensor at the output shaft). If some deviations occur, the current sensor value may be corrected in the improved calibrating process.

Further, the method may comprise at least one of the following:

- storing the angular positions of the output shaft obtained by the angular position sensor,
- storing the real angular positions of the output shaft calculated using the angular positions of the motor shaft,
- calculating deviations between the angular positions of the output shaft obtained by the angular position sensor and the real angular positions of the output shaft calculated using the angular positions and/or the number of revolutions of the motor shaft,
- storing the deviations,
  especially in a memory unit of the actuator,
- calibrating the incremental sensor using the deviations.

Thus, a table of detected sensor values of calculated angular positions and of deviations between them may then be provided. With the help of such a table, improved calibration results may be achieved.

Memory unit may be provided inside or outside of the actuator, e.g. via connector.

In one preferable embodiment, the method may comprise at least one of the following:

- spinning the electrical motor,
- checking sensor values of the angular position sensor every certain time slot, for example every 3 ms, until a first rollover of the electrical motor,
- continuing to spin the motor,
- checking sensor values of the angular position sensor every certain time slot, for example every 3 ms, until a second rollover of the electrical motor,

- calculating deviations between sensor values of the angular position sensor and corresponding calculated positions of the output shaft using the angular positions and/or the number of revolutions of the motor shaft,
- calibrating the angular position sensor using the deviations.

Thus, one preferable way how to execute the method may be provided, in order to be able to calibrate the angular position sensor with improved resolution.

Advantageously, the method may be executed during a regular operation of the actuator. Thus, an improved actuator may be provided, which can serve for improved, reliable and safe vehicle applications.

Beneficially, the method may be executed in a recurring, periodic, event-specific way, for example each time the actuator is starting, and/or upon a request, for example of a user of the vehicle.

The invention further provides:
a computer program product, comprising instructions, which, when the computer program is executed by a computer, cause the computer to carry out the method as described above. With the help of the computer program product, the same advantages may be achieved as described above.

The invention further provides:

an electronic control unit, comprising a memory unit and a control unit, wherein in the memory unit a code is stored, wherein when the code is executed by the control unit,
the method according to one of the preceding steps is executed. With the help of the electronic control unit, the same advantages may be achieved as described above.
Preferably, the deviations may be stored in the memory unit, especially to be used for calibrating the angular position sensor.

The invention further provides:
an actuator, preferably for a vehicle application, e. g. for engine control, steering control, cooling control etc., comprising an angular position sensor and an electronic control unit as described above configured for calibrating the angular position sensor.

With the help of the actuator, the same advantages may be achieved as described above.

The invention is explained in more detail below with reference to the accompanying drawings. The following exemplary description includes:

Fig. 1 an exemplary actuator in an exploded view,
Fig. 2 an exemplary procedure for recording sensor values,
Fig. 3 an exemplary procedure for recording sensor values, and
Fig. 4 an exemplary table with sensor values and deviations.

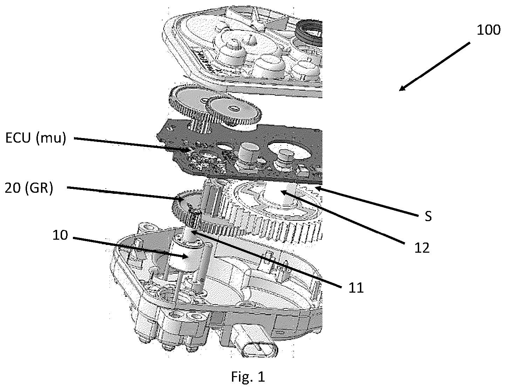

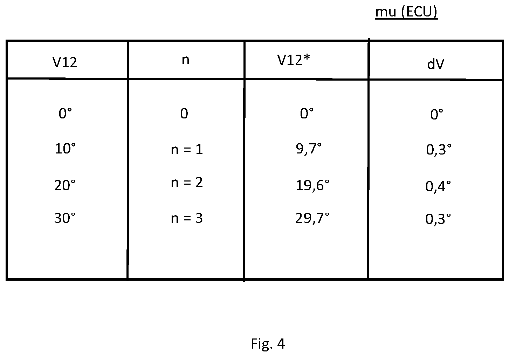

Fig. 1 to 4 serve to explain the inventive idea.
In will be provided:
a method for calibrating an angular position sensor S, e. g. a contactless inductive position sensor (CIPOS) or a Hall sensor or the like, e. g. arranged at an output shaft 12 of an actuator 100, wherein the actuator 100 is preferably provided for a vehicle application, e. g. for engine control, steering control, cooling control etc.

The actuator 100 may comprise following components:

- an electrical motor 10, especially a brushless dc motor, configured to drive a motor shaft 11 and to provide an incremental sensor using a motor back EMF signal,
- a gear mechanism 20 configured to provide a gear ratio GR between the motor shaft 11 and the output shaft 12 of the actuator 100.

The angular position sensor S may be for example mounted at an output shaft 12 of an actuator 100 or in other gear stages of the gear mechanism 20. There may be actuators 100, where the exact position of the output shaft 12 may be needed. There may be also actuators 100, where other gear stages and their positions may be of interest. The output shaft 12 may be in general a shaft in a particular stage of the gear mechanism 20.

The method comprises the following actions / method steps:

- operating the angular position sensor S to obtain angular positions V12 of the output shaft 12 (for example as an angle between 0° and 360°),
- operating the electrical motor 10 as the incremental sensor to determine angular positions V11 (for example as an angle between 0° and 360°) and/or a number n (for example 1, 2, 3 etc.) of revolutions of the motor shaft 11,
- calculating real angular positions V12* of the output shaft 12 using the angular positions V11 and/or the number n of revolutions of the motor shaft 11,
- comparing the angular positions V12 of the output shaft 12 obtained by the angular position sensor S and the real angular positions V12* of the output shaft 12 calculated using the angular positions V11 of the motor shaft 11,
- calibrating the angular position sensor S in dependence on the comparing.

Back EMF (or back electromotive force) is a counter voltage induced through the magnetic field in the motor. In sensorless commutation, no separate sensors are used to detect the current rotor position; instead, the information is obtained indirectly by measuring electrical parameters on the coils. There are several methods available for this, such as detecting the rotor position via the counter voltage triggered in the coils of the stator, which is analyzed by an electronic control unit ECU.

The electrical motor 10 used as an incremental sensor may count the number n of electrical rotations and/or rollovers of the electrical motor 10, especially of revolutions of the motor shaft 11.

The method uses the signal of motor commutation (and preferably the fixed gear ratio of the gear mechanism 20) to calibrate the actuator internal position sensor at the output shaft 12 of the actuator 100. This may be executed completely actuator internally and without external position sensor.

Different benefits may be achieved with the help of this method:

- production time and effort of the actuator 100 may be drastically reduced due to this calibration process,
- computational time and effort may be drastically reduced,
- hardware components, such as external position sensor, may be omitted,
- improved calibration results may be provided, etc.

Preferably, the gear ratio GR of the gear mechanism 20 may be considered by calculating the real angular positions V12* of the output shaft 12 using the angular positions V11 and/or the number n of revolutions of the motor shaft 11.

The angular position V12* of the output shaft 12 (which may be understood as an angle between 0° and 360°) may be especially calculated as a function of a number n of revolutions of the motor shaft 11 and of a gear ration GR:

$$V12^* = f\,(n,\,GR).$$

The exact angular position V11 of the motor shaft 11 may be calculated dependently on the number n of revolutions of the motor shaft 11 and the resolution of the incremental sensor (provided by the electrical motor 10).

By knowing the exact angular position V11 and/or the number n of revolutions of the motor shaft 11 (using the electrical motor 10 as an incremental sensor) and the gear ratio GR of the gear mechanism 20 between the motor shaft 11 and an output shaft 12 of the actuator 100, the real angular position of the output shaft 12 may be calculated very precisely.

The angular position sensor S may be operating to obtain an angular position V12 of the output shaft 12 (or with other words one sensor value) every certain time slot, for example every 3 ms, during an operation of the electrical motor 10 as the incremental sensor. Advantageously, the angular position sensor S may be operating to obtain a plurality of angular positions V12 of the output shaft 12 (or with other words a plurality of sensor values) for at least two electrical rotations and/or rollovers of the electrical motor 10, especially for at least two revolutions of the motor shaft 11.

Accordingly, it may be advantageous, that operating the electrical motor 10, especially with a constant speed, e. g. 300 rad/s, as the incremental sensor may be executed for at least two electrical rotations and/or rollovers of the electrical motor 10, especially for at least two revolutions of the motor shaft 11.

Thus, a maximal angular position (or a maximal sensor value) and a minimal angular position (or a minimal sensor value) of the output shaft 12 may be determined. Furthermore, a resolution of the angular position sensor S may be calculated.

In other words, it may be beneficial to be able to obtain a whole set of sensor values between a minimal sensor value and a maximal sensor value. Moreover, a resolution of the angular position sensor S may be determined in dependence on a minimal sensor value and a maximal sensor value.

Thus, the real angular position V12* of the output shaft 12 may be precisely calculated using motor shaft angular position V11 and the gear ration GR.

The calculated angular position of the output shaft 12 may then be compared to the current sensor value (that is the current angular position V12 of the output shaft 12 according to the actuator internal angular position sensor S at the output shaft 12).

If some deviations occur, the current sensor value may then be corrected in the proposed calibrating process.

Further, the method may comprise at least one of the following:

- storing the angular positions V12 of the output shaft 12 obtained by the angular position sensor S,
- storing the real angular positions V12* of the output shaft 12 calculated using the angular positions V11 of the motor shaft 11,
- calculating deviations dV between the angular positions V12 of the output shaft 12 obtained by the angular position sensor S and the real angular positions V12* of the output shaft 12 calculated using the angular positions V11 and/or the number n of revolutions of the motor shaft 11,
- storing the deviations dV, especially in a memory mu of the actuator 100,
- calibrating the incremental sensor S using the deviations dV.

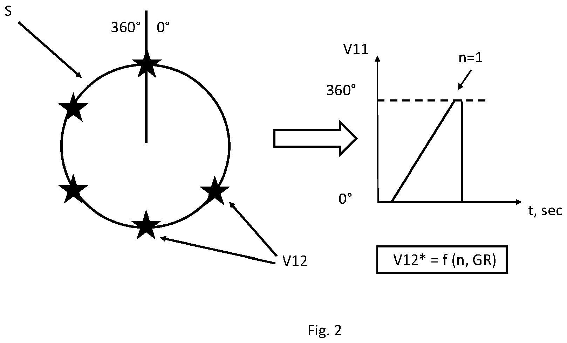

In one preferable embodiment, the method may comprise the following method steps, as fig. 2 suggests:

- spinning the electrical motor 10,
- checking sensor values of the angular position sensor S every certain time slot, for example every 3 ms, until a first rollover of the electrical motor 10.

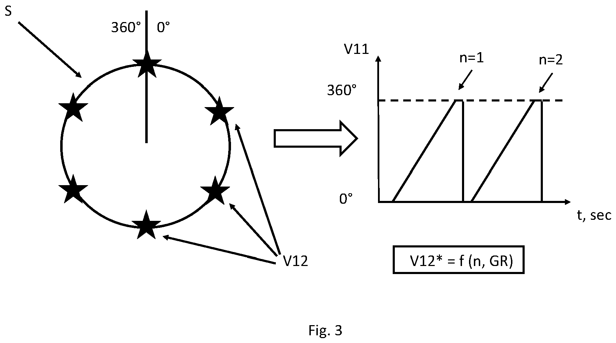

In this preferable embodiment, the method may comprise the following method steps, as fig. 3 suggests:

- continuing to spin the motor 10,
- checking sensor values of the angular position sensor S every certain time slot, for example every 3 ms, until a second rollover of the electrical motor 10.

After that, the method may comprise the following method steps in this preferable embodiment:

- calculating deviations dV between sensor values of the angular position sensor S and corresponding calculated positions of the output shaft 12 using the angular positions V11 and/or the number n of revolutions of the motor shaft 11,
- calibrating the angular position sensor S using the deviations dV.

Advantageously, the method may be executed during a regular operation of the actuator 100, beneficially in a recurring, periodic, event-specific way, for example each time the actuator 100 is starting, and/or upon a request, for example of a user of the vehicle.
A corresponding computer program product and a corresponding electronic control unit ECU represent also aspects of the present invention.
A corresponding actuator 100, preferably for a vehicle application, e. g. for engine control, steering control, cooling control etc. also represents an aspect of the present invention.
The above description of the figures describes the present invention solely by way of example. Of course, individual features of the embodiments can be freely combined with one another without departing from the scope of the invention, provided this is technically expedient.

List of reference signs

| 100 | actuator |
| 10 | electrical motor |
| 11 | motor shaft |
| 12 | output shaft |
| 20 | gear mechanism |
| S | angular position sensor |
| ECU | electronic control unit |
| mu | memory unit |
| GR | gear ration |
| n | number of electrical rotations and/or rollovers of the electrical motor, that is number of revolutions of the motor shaft (provided by the sensorless motor commutation) |
| V11 | angular positions of the motor shaft (provided by the sensorless motor commutation) |
| V12 | angular positions of the output shaft (measured |

by the angular position sensor), respective sensor values
V12* real/calculated angular positions of the output shaft (calculated using the angular positions and/or the number of revolutions of the motor shaft and preferably the gear ration), respective comparative values
dV deviations

**Claims**

1. A method for calibrating an angular position sensor (S), e. g. a contactless inductive position sensor (CIPOS) or a Hall sensor, especially arranged at an output shaft (12) of an actuator (100), wherein the actuator (100) is preferably provided for a vehicle application, e. g. for engine control, steering control, cooling control etc.,

   and wherein the actuator (100) comprises:

   - an electrical motor (10), especially a brushless dc motor, configured to drive a motor shaft (11) and to provide an incremental sensor using a motor back EMF signal,
   - a gear mechanism (20) configured to provide a gear ratio (GR) between the motor shaft (11) and the output shaft (12) of the actuator (100),

   the method comprising:

   - operating the angular position sensor (S) to obtain angular positions (V12) of the output shaft (12),
   - operating the electrical motor (10) as the incremental sensor to determine angular positions (V11) and/or a number (n) of revolutions of the motor shaft (11),
   - calculating real angular positions (V12*) of the output shaft (12) using the angular positions (V11) and/or the number (n) of revolutions of the motor shaft (11),
   - comparing the angular positions (V12) of the output shaft (12) obtained by the angular position sensor (S) and the real angular positions (V12*) of the output shaft (12) calculated using the angular positions (V11) and/or the number (n) of revolutions of the motor shaft (11),
   - calibrating the angular position sensor (S) in dependence on the comparing.

2. The method according to claim 1, wherein the gear ratio (GR) of the gear mechanism (20) is considered by calibrating the angular position sensor (S), especially by calculating the real angular positions (V12*) of the output shaft (12) using the angular positions (V11) of the motor shaft (11).

3. The method according to claim 1 or 2, wherein the angular position sensor (S) is operating to obtain an angular position (V12) of the output shaft (12) every certain time slot, for example every 3 ms, during an operation of the electrical motor (10) as the incremental sensor.

4. The method according to claim 1 or 2,

   wherein the angular position sensor (S) is operating to obtain a plurality of angular positions (V12) of the output shaft (12) for at least two electrical rotations and/or rollovers of the electrical motor (10), especially for at least two revolutions of the motor shaft (11),
   advantageously to be able to detect a maximal angular position and a minimal angular position of the output shaft (12) and/or to calculate a resolution of the angular position sensor (S).

5. The method according to one of the preceding claims,

   further comprising:

      - operating the electrical motor (10), especially with a constant speed, e. g. 300 rad/s, as the incremental sensor for at least two electrical rotations and/or rollovers of the electrical motor (10), especially for at least two revolutions of the motor shaft (11),

   advantageously to be able to detect a maximal angular position and a minimal angular position of the output shaft (12) and/or calculate a resolution of the angular position sensor (S).

6. The method according to one of the preceding claims,
   further comprising at least one of the following:

      - storing the angular positions (V12) of the output shaft (12) obtained by the angular position sensor (S),
      - storing the real angular positions (V12*) of the output shaft (12) calculated using the angular positions (V11) of the motor shaft (11),
      - calculating deviations (dV) between the angular positions (V12) of the output shaft (12) obtained by the angular position sensor (S) and the real angular positions (V12*) of the output shaft (12) calculated using the angular positions (V11) and/or the number (n) of revolutions of the motor shaft (11),
      - storing the deviations (dV),

especially in a memory unit (mu) of the actuator (100),
- calibrating the incremental sensor (S) using the deviations (dV).

7. The method according to one of the preceding claims, comprising the following steps:

      - spining the electrical motor (10),
      - checking sensor values of the angular position sensor (S) every certain time slot, for example every 3 ms, until a first rollover of the electrical motor (10),
      - continuing to spin the motor (10),
      - checking sensor values of the angular position sensor (S) every certain time slot, for example every 3 ms, until a second rollover of the electrical motor (10),
      - calculating deviations (dV) between sensor values of the angular position sensor (S) and corresponding calculated positions of the output shaft (12) using the angular positions (V11) and/or the number (n) of revolutions of the motor shaft (11),
      - storing the deviations (dV),
      especially in a memory unit (mu) of the actuator (100),
      - calibrating the angular position sensor (S) using the deviations (dV).

8. The method according to one of the preceding claims,
   wherein the method is executed during a regular operation of the actuator (100).

9. The method according to one of the preceding claims,
   wherein the method is executed in a recurring, periodic, event-specific way, for example each time the actuator (100) is starting, and/or upon a request, for example of a user of the vehicle.

10. A computer program product, comprising instructions, which, when the computer program is executed by a computer, cause the computer to carry out the method according to one of the preceding claims.

11. An electronic control unit (ECU), comprising a memory unit (mu) and a control unit (cu), wherein in the memory unit (mu) a code is stored, wherein when the code is executed by the control unit (cu), the method according to one of the preceding claims is executed.

12. The electronic control unit (ECU) according to the preceding claim,
    wherein the deviations (dV) are stored in the memory unit (mu), especially to be used for calibrating the angular position sensor (S).

**13.** An actuator (100), preferably for a vehicle application, e. g. for engine control, steering control, cooling control etc., comprising an angular position sensor (S) and an electronic control unit (ECU) according to one of the preceding claims 11 or 12 configured for calibrating the angular position sensor (S).

Fig. 1

Fig. 2

Fig. 3

mu (ECU)

| V12 | n | V12* | dV |
|---|---|---|---|
| 0° | 0 | 0° | 0° |
| 10° | n = 1 | 9,7° | 0,3° |
| 20° | n = 2 | 19,6° | 0,4° |
| 30° | n = 3 | 29,7° | 0,3° |

Fig. 4

**EUROPEAN SEARCH REPORT**

Application Number

EP 24 21 2392

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | CN 110 168 875 B (VALEO SYSTEMES DESSUYAGE) 3 June 2022 (2022-06-03) * figures 2, 4, 6, 8, 11 * * claims 1-6, 9-11 * ----- | 1-13 | INV. G01D5/14 G01D18/00 G01D5/20 H02K11/21 |
| A | EP 3 591 832 A1 (NSK LTD [JP]) 8 January 2020 (2020-01-08) * paragraph [0152] * ----- | 1-13 | H02P6/16 H02P6/18 |
| A | EP 2 968 709 B1 (CLEARMOTION INC [US]) 2 October 2019 (2019-10-02) * paragraph [0217] * ----- | 1-13 | |
| A | EP 1 489 735 A2 (BVR TECHNOLOGIES COMPANY [US]) 22 December 2004 (2004-12-22) * figure 1 * * paragraphs [0004], [0005], [0020] – [0023], [0035], [0036], [0042], [0046] – [0051] * ----- | 1-13 | |
| | | | TECHNICAL FIELDS SEARCHED (IPC) |
| | | | G01D H02P H02K |

The present search report has been drawn up for all claims

| Place of search | Date of completion of the search | Examiner |
|---|---|---|
| Munich | 11 April 2025 | Kuchenbecker, J |

EPO FORM 1503 03.82 (P04C01)

## ANNEX TO THE EUROPEAN SEARCH REPORT
## ON EUROPEAN PATENT APPLICATION NO.

EP 24 21 2392

This annex lists the patent family members relating to the patent documents cited in the above-mentioned European search report.
The members are as contained in the European Patent Office EDP file on
The European Patent Office is in no way liable for these particulars which are merely given for the purpose of information.

11-04-2025

| Patent document cited in search report | | Publication date | Patent family member(s) | | Publication date |
|---|---|---|---|---|---|
| CN 110168875 | B | 03-06-2022 | CN | 110168875 A | 23-08-2019 |
| | | | EP | 3542450 A1 | 25-09-2019 |
| | | | FR | 3059174 A1 | 25-05-2018 |
| | | | JP | 6949958 B2 | 13-10-2021 |
| | | | JP | 2020513720 A | 14-05-2020 |
| | | | US | 2020067432 A1 | 27-02-2020 |
| | | | WO | 2018091302 A1 | 24-05-2018 |
| EP 3591832 | A1 | 08-01-2020 | CN | 110754037 A | 04-02-2020 |
| | | | EP | 3591832 A1 | 08-01-2020 |
| | | | US | 2020403543 A1 | 24-12-2020 |
| | | | WO | 2019216022 A1 | 14-11-2019 |
| EP 2968709 | B1 | 02-10-2019 | EP | 2968709 A2 | 20-01-2016 |
| | | | EP | 3626485 A1 | 25-03-2020 |
| | | | EP | 4450845 A2 | 23-10-2024 |
| | | | US | 2014294601 A1 | 02-10-2014 |
| | | | US | 2014294625 A1 | 02-10-2014 |
| | | | US | 2014297113 A1 | 02-10-2014 |
| | | | US | 2014297116 A1 | 02-10-2014 |
| | | | US | 2014297117 A1 | 02-10-2014 |
| | | | US | 2018154723 A1 | 07-06-2018 |
| | | | US | 2024300275 A1 | 12-09-2024 |
| | | | US | 2024391286 A1 | 28-11-2024 |
| | | | WO | 2014145018 A2 | 18-09-2014 |
| EP 1489735 | A2 | 22-12-2004 | CA | 2471203 A1 | 18-12-2004 |
| | | | EP | 1489735 A2 | 22-12-2004 |
| | | | US | 6791219 B1 | 14-09-2004 |

EPO FORM P0459

For more details about this annex : see Official Journal of the European Patent Office, No. 12/82